# EUROPEAN PATENT APPLICATION

(11) **EP 4 250 471 A1**
(43) Date of publication of application: **27.09.2023**
(21) Application number: 20967902.6
(22) Date of filing: 31.12.2020
(51) Int. Cl.: H01P 1/18, H01Q 3/32

(54) **ELECTRONIC DEVICE AND ANTENNA**

(71) Applicant: Huawei Technologies Co., Ltd., Shenzhen, Guangdong 518129 (CN)
(72) Inventor: LI, Weimin, Shenzhen, Guangdong 518129 (CN); LIU, Xinming, Shenzhen, Guangdong 518129 (CN); WANG, Chongyang, Shenzhen, Guangdong 518129 (CN); ZHANG, Hongzhi, Shenzhen, Guangdong 518129 (CN)
(74) Representative: Goddar, Heinz J.
(86) International application number: PCT/CN2020/142489
(87) International publication number: WO 2022/141564

(57) **Abstract**

This application provides an electronic component, capable of simplifying a structure of an electronic component. The electronic component includes a printed circuit board PCB and a cavity. An inner wall of the cavity is provided with at least one groove for fixing the PCB. A first groove in the at least one groove includes a first side wall and a second side wall. The first side wall and the second side wall form an opening of the first groove. A length of the first side wall in a first direction is greater than that of the second side wall. The first direction is parallel to a direction of the opening. The first side wall is provided with at least one first raised part. The first raised part protrudes from the first side wall to the second side wall along a second direction. The second direction is perpendicular to the first direction.

## Description

### TECHNICAL FIELD

This application relates to the field of antenna technologies, and in particular, to an electronic component and an antenna.

### BACKGROUND

A base station antenna is an important part of a wireless communication system. As wireless communication develops, network environment is complex and changeable, and resources for sites and steel structure communication tower platforms are insufficient, resulting in a relatively high requirement on the base station antenna. The use of a remote electrical tilt antenna can implement continuous adjustment of a downtilt angle of a vertical beam, and more flexible network coverage. A beam tilt angle of the remote electrical tilt antenna can be controlled and changed remotely as required. A coverage effect of the remote electrical tilt antenna is better than that of a mechanical downtilt antenna. Therefore, the remote electrical tilt antenna is important for network optimization.

A phaser is a key component of the remote electrical tilt antenna. As the phaser is a core component, demands for a structural simplification design of the phaser has become a mainstream trend.

### SUMMARY

This application provides an electronic component and an antenna, to simplify a structure of a phaser.

According to a first aspect, an electronic component is provided, including a printed circuit board PCB and a cavity. An inner wall of the cavity is provided with at least one groove for fixing the PCB. A first groove in the at least one groove includes a first side wall and a second side wall. The first side wall and the second side wall form an opening of the first groove. A length of the first side wall in a first direction is greater than that of the second side wall. The first direction is parallel to a direction of the opening. The first side wall is provided with at least one first raised part. The first raised part protrudes from the first side wall to the second side wall along a second direction. The second direction is perpendicular to the first direction.

With reference to the first aspect, in some implementations of the first aspect, a vertical distance between a side of the first raised part close to the inner wall of the cavity and the inner wall of the cavity is greater than the length of the second side wall in the first direction.

With reference to the first aspect, in some implementations of the first aspect, a distance between an outer end of the first raised part and the second side wall in the second direction is greater than 0.

With reference to the first aspect, in some implementations of the first aspect, the electronic component is a phaser.

According to a second aspect, an electronic component is provided, including a cavity and at least one welding wall. The at least one welding wall is disposed on an outer wall of the cavity. At least one end of the welding wall is connected to the outer wall of the cavity. A cavity structure is formed between the welding wall and the outer wall of the cavity. At least one through hole is disposed on the welding wall. The outer wall of the cavity is provided with an operation hole corresponding to the through hole.

With reference to the second aspect, in some implementations of the second aspect, the electronic component further includes a printed circuit board PCB and a cable. The PCB is located in the cavity. An inner conductor of the cable passes through the through hole and the operation hole and is welded to the PCB, and an outer conductor of the cable is welded to the welding wall.

With reference to the second aspect, in some implementations of the second aspect, the electronic component is a phaser.

According to a third aspect, an antenna is provided, including an antenna unit and the phaser according to the foregoing first aspect and the second aspect, connected to the antenna unit.

### BRIEF DESCRIPTION OF DRAWINGS

FIG. 1 is a schematic diagram of a structure of a dielectric phaser;
FIG. 2 is a schematic diagram of a three-dimensional structure of a cavity 4 shown in FIG. 1 and a schematic diagram of a section of the cavity 4 in a cavity height direction;
FIG. 3 is a schematic diagram of a section of an electronic component in a cavity height direction according to an embodiment of this application;
FIG. 4 is a schematic diagram of a three-dimensional structure of a first raised part according to an embodiment of this application;
FIG. 5 is a three-dimensional schematic diagram of an electronic component according to an embodiment of this application;
FIG. 6 is a second schematic diagram of a connection section between a welding wall and an outer wall of a cavity in a cavity height direction according to an embodiment of this application;
FIG. 7 is a third schematic diagram of a connection section between a welding wall and an outer wall of a cavity in a cavity height direction according to an embodiment of this application;
FIG. 8 is a schematic diagram of a structure of an antenna according to an embodiment of this application; and
FIG. 9 is a schematic diagram of a structure of a base station according to an embodiment of this application.

### DESCRIPTION OF EMBODIMENTS

The following describes technical solutions of this application with reference to accompanying drawings.

A phaser (phaser) is an apparatus that can adjust a phase of a wave. The phaser implements a phase shift function by changing a phase difference of each interface, so as to implement a downtilt adjustment function for an antenna. The phaser is widely used in fields such as radar, missile posture control, accelerator, communication, instrument, and even music. A transmission medium may introduce a phase shift to electromagnetic waves transmitted therein, which is the principle of an early analog phaser. As modem electronic technologies develop, a digital phase shift is implemented by using analog to digital (analog to digital, A/D) conversion and digital to analog (digital to analog, D/A) conversion. The digital phase shift is a discontinuous phase shift technology, but is characterized by high phase shift precision. Currently, one of mainstream phasers of an antenna is dielectric phaser.

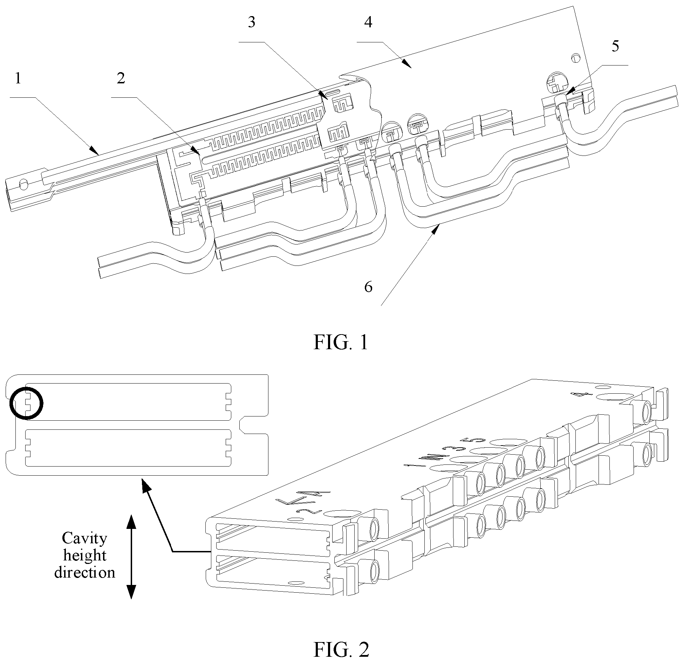

FIG. 1 is a schematic diagram of a structure of a dielectric phaser. The phaser in FIG. 1 usually includes a dielectric driving piece 1, a printed circuit board (printed circuit board, PCB) 2, a sliding medium 3, a cavity 4, a ground block 5, and a cable 6. As shown in FIG. 1, the ground block 5 is added to the profile cavity 4. The cavity 4 is fully electroplated. The cable 6 is welded to the cavity 4 by induction welding or electric resistance welding.

FIG. 2 is a schematic diagram of a three-dimensional structure of a cavity 4 shown in FIG. 1 and a schematic diagram of a section of the cavity 4 in a cavity height direction. Through gaps between upper and lower walls of a guide groove shown in the circle in FIG. 2, the PCB 2 is fixed to the cavity 4 in the foregoing phaser. Because the gaps for fixing PCB necessarily meet electrical specifications first, a PCB having a thickness of 20 mil (mil) or above 20 mil can be fixed by a guide groove integrally formed in the profile cavity. Because the height of the guide groove for fixing PCB in a thickness direction exceeds that of current profile for forming, a PCB less than 20 mil cannot be fixed by the guide groove integrally formed in the profile cavity in a case of meeting the electrical specifications. If a PCB having a thickness of less than 20 mil needs to be used, a component such as an auxiliary plastic component for fixing need to be added to fix the PCB. This results in an increased quantity of components of the phaser and complex mounting. In addition, costs of the phaser also increase.

In view of this, to simplify a structure of the phaser, the guide groove in the cavity 4 is improved in this application, so that the use of the plastic components for auxiliary fixing can be reduced or eliminated, thereby reducing mounting steps and mounting costs.

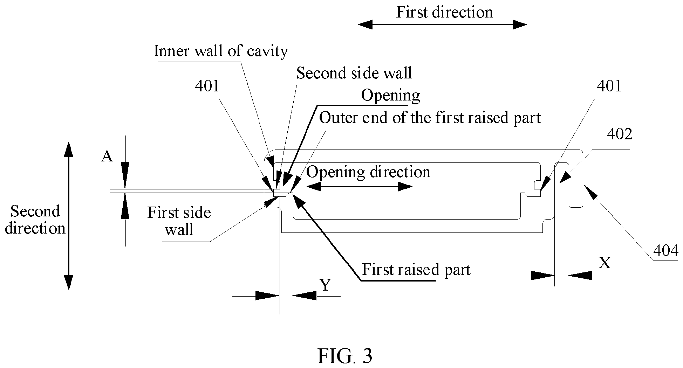

FIG. 3 is a schematic diagram of a section of an electronic component in a cavity height direction according to an embodiment of this application.

The electronic component includes a PCB and a cavity. An inner wall of the cavity is provided with at least one groove for fixing the PCB. The groove 401 includes a first side wall and a second side wall. The first side wall and the second side wall form an opening of the grooves 401. A length of the first side wall in a first direction is greater than that of the second side wall (that is, Y in FIG. 3 is greater than 0). The first direction is parallel to a direction of the opening. The first side wall is provided with at least one first raised part. The first raised part protrudes from the first side wall to the second side wall along a second direction. The second direction is perpendicular to the first direction. The second direction and the cavity height direction in FIG. 3 are a same direction.

Optionally, a vertical distance between a side of the first raised part close to an inner wall of the cavity and the inner wall of the cavity is greater than the length of the second side wall in the first direction. In this way, a distance between the first side wall and the second side wall may not be limited to existing machining precision. An actual distance between the first side wall and the second side wall may be adjusted according to a height of the first raised part. The inner wall of the cavity herein refers to an inner wall on one side of the first side wall and the second side wall in the cavity.

It may also be understood that, the first raised part is located within a first area of the first side wall. The first area is an area outside a first projection range on the first side wall. The first projection is a projection of the second side wall on the first side wall along the second direction. For example, the first raised part may be located at an edgemost position of the first side wall on the first direction in FIG. 3, or the first raised part may be located at any position where the first side wall is longer than the second side wall in the first direction in FIG. 3, that is, at any position corresponding to Y in the first side wall.

Optionally, a distance between an outer end of the first raised part and the second side wall in the second direction is greater than 0 (that is, A in FIG. 3 is greater than 0). The outer end of the first raised part is an end relatively close to the second side wall in the second direction. The distance may also be considered as approximately a thickness of a PCB that can be mounted in the groove 401.

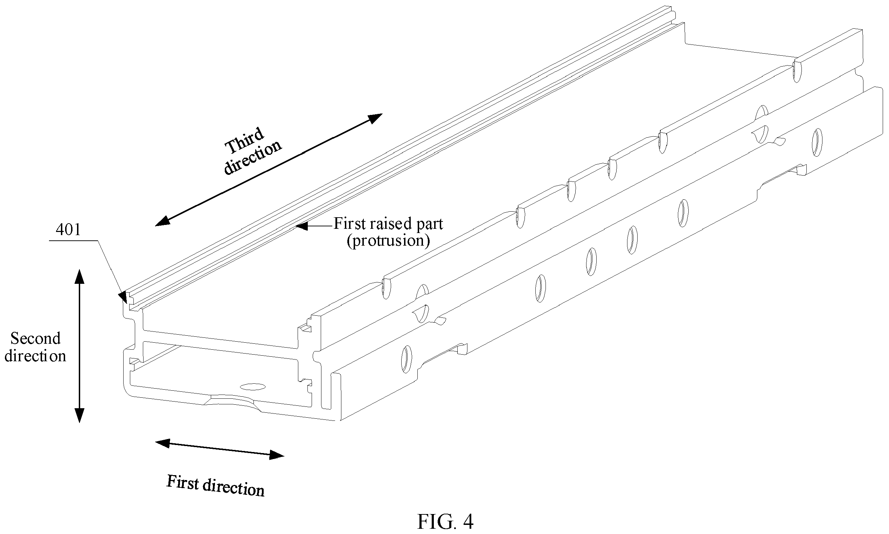

Because FIG. 3 is a schematic diagram of a section of the groove 401, the first raised part is a protrusion section viewed on a section in the second direction. FIG. 4 is a schematic diagram of a three-dimensional structure of a first raised part according to an embodiment of this application. In practical production, the first raised part may be a protrusion of any shapes that protrudes on the first side wall along a third direction in FIG. 4. Alternatively, the first raised part may be a protrusion section or a raised block of any shapes. Alternatively, the first raised part may be any combination of a protrusion, a raised block, or a protrusion section. The third direction is a direction perpendicular to both the first direction and the second direction. A quantity and a shape of the first raised part on the first side wall are not specifically limited in this application. In addition, shapes or structures of other parts of the cavity and the side wall are not limited in this application.

FIG. 3 merely schematically shows a pair of grooves 401 including two opposite openings. In practical production, only one of the grooves 401 may be included, and a staggered design of the groove 401 may not be used for the grooves in the opposite directions. For example, the design of the guide groove shown in the circle in FIG. 2 is still used. Another end of the PCB is fixed by adding a plastic component for auxiliary fixing, or by a groove having another shape or structure.

In addition, FIG. 3 only schematically shows a schematic diagram in which the first side wall is located below the second side wall. Optionally, the first side wall may be located above the second side wall. This is not specifically limited in this application.

Optionally, the first side wall and the second side wall are not limited to a parallel relationship, and the two side walls may be at any angle.

Optionally, the groove 401 in this embodiment may be applied to any electronic component that needs to fix a PCB or another plate-like element. For example, the electronic component may be a phaser, or may be a filter, a power splitter, a coupler, a duplexer, a combiner, or the like.

The groove 401 provided in the foregoing embodiments can satisfy fixing of a PCB board less than 20 mil. Because the lengths of the two side walls forming the groove opening in the circles in FIG. 2 are the same, existing machining precision cannot reach less than 20 mil (in other words, the gap between the upper and lower walls of the guide groove shown in the circle in FIG. 2 cannot be machined to less than 20 mil). In this application, a first raised part is disposed on the relatively long first side wall by a staggered design of the first side wall and the second side wall, so that a distance (that is, the distance A in FIG. 3) between the two side walls can be reduced to less than 20 mil. For example, a distance between the first side wall and the second side wall in the second direction is 20 mil. The first raised part protrudes from the first side wall to the second side wall in the second direction by 5 mil. Because of existence of the first raised part, the distance A between the first side wall and the second side wall may practically be reduced to 15 mil without being limited to existing machining precision. In this way, the use of the plastic component for auxiliary fixing can be reduced or eliminated, and fixing of PCB less than 20 mil can be implemented.

In addition, in the phaser shown in FIG. 1, a grounding welding feature is processed on the cavity 4 by a mechanical processing manner, and the cable 6 is welded to the cavity 4 by induction welding or resistance welding. To ensure weldability, in addition to processing a cable hole, a feature such as a heat resistance shape needs to be processed, resulting in complex machining.

In view of this, to reduce complexity caused by processing a feature such as a heat resistance shape in a manufacturing process of the phaser, the cavity 4 is improved in this application. This can reduce or eliminate mechanical processing of a heat resistance structure.

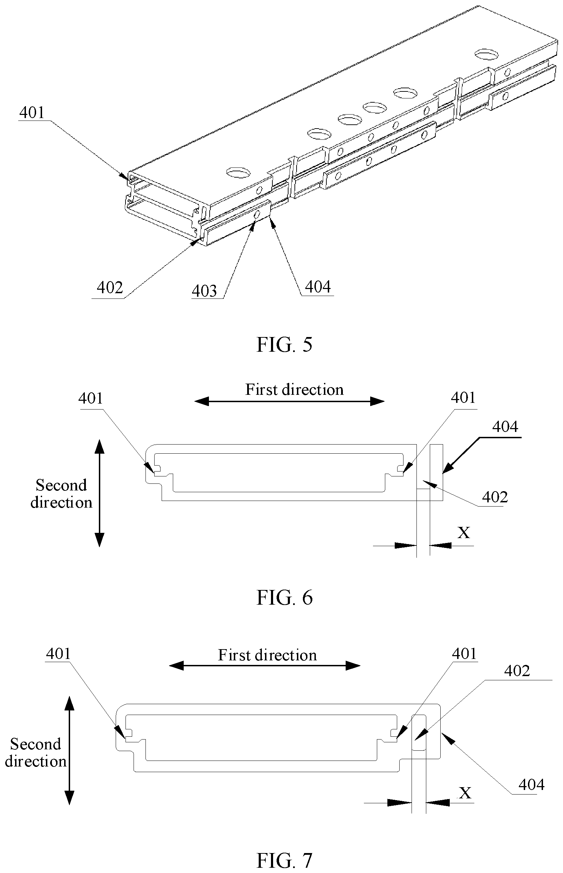

FIG. 5 is a three-dimensional schematic diagram of an electronic component according to an embodiment of this application.

The electronic component includes a cavity and at least one welding wall. The at least one welding wall 404 is disposed on an outer wall of the cavity. At least one end of the welding wall 404 is connected to the outer wall of the cavity. A cavity structure is formed between the welding wall 404 and the outer wall of the cavity (to be specific, a gap 402 is formed between the outer wall of the cavity and the welding wall 404). At least one through hole 403 is disposed on the welding wall 404. The outer wall of the cavity is provided with an operation hole corresponding to the through hole 403.

FIG. 3 provides a first schematic diagram of a connection section between the welding wall and the outer wall of a cavity in a cavity height direction. The cavity height direction herein may be understood as the second direction in FIG. 3. Details are not described herein again. An upper end of the welding wall 404 in the second direction (to be specific, the cavity height direction) is connected to the outer wall of the cavity. A lower end of the welding wall 404 in the second direction is not connected to the outer wall of the cavity. The gap 402 formed by a section of the welding wall 404 and the outer wall of the cavity in the second direction is an unclosed rectangle having an opening facing downward. A width of the gap 402 is greater than 0 (that is, X in FIG. 3 is greater than 0).

FIG. 6 is a second schematic diagram of a connection section between a welding wall and an outer wall of a cavity in a cavity height direction according to an embodiment of this application. Different from FIG. 3, the upper end of the welding wall 404 in the second direction (that is, the cavity height direction) is not connected to the outer wall of the cavity. The lower end of the welding wall 404 in the second direction is connected to the outer wall of the cavity. The gap 402 formed by a cross section of the welding wall 404 and the outer wall of the cavity in the second direction is an unclosed rectangle with an opening upward. A width of the gap 402 is greater than 0 (that is, X in FIG. 6 is greater than 0).

FIG. 7 is a third schematic diagram of a connection section between a welding wall and an outer wall of a cavity in a cavity height direction according to an embodiment of this application. Both the upper end and the lower end of the welding wall 404 in the second direction (that is, the cavity height direction) are connected to the outer wall of the cavity. The gap 402 formed by the welding wall 404 and the outer wall of the cavity in the second direction is a closed rectangle. A width of the gap 402 is greater than 0 (that is, X in FIG. 7 is greater than 0).

It shall be understood that FIG. 3, FIG. 6, and FIG. 7 are merely schematic diagrams, and shapes and structures of the gap are not limited in this application. For example, a specific shape of the gap 402 is not limited in this application, and may be any shape other than the rectangular shapes shown in FIG. 3, FIG. 6, and FIG. 7.

It should be noted that, the one end of at least one end of the welding wall 404 connected to the outer wall of the cavity is not limited to that the upper edge end or the lower edge end of the welding wall 404 in the second direction is connected to the outer wall of the cavity. For example, a middle end of the welding wall 404 may be protrudingly connected to the outer wall of the cavity, or a position between the upper edge end or the lower edge end and the middle end is protrudingly connected to the outer wall of the cavity. Locations and quantities of connection points connecting the welding wall to the outer wall of the cavity are not limited in this application.

Optionally, the electronic component further includes a PCB located in the cavity. Optionally, the electronic component may further include a cable. The cable passes through the through hole 403 and the operation hole and is connected to the PCB. The cable may be a coaxial cable, including an inner conductor (inner core), a dielectric layer, and an outer conductor. The inner conductor and the dielectric layer may pass through the through hole and the working hole. The inner conductor may be welded to the PCB. The outer conductor may be welded to the welding wall 404.

Optionally, the electronic component in this embodiment may be a phaser, or may be a filter, a power splitter, a coupler, a duplexer, a combiner, or the like.

In this embodiment of this application, the cable (the outer conductor) is welded to the welding wall 404. A cavity structure is formed between the welding wall 404 and the outer wall of the cavity. In this way, some heat generated in a process of welding the cable may be dissipated to the air through the cavity structure. Compared with that in FIG. 1, in which the cable is directly welded to the cavity wall, machining of the heat-resistance structure can be reduced or eliminated, thereby reducing processing costs.

It should be noted that, the groove 401 designed in a staggered manner and the gap 402 formed by connecting the cavity and the welding wall in this application may be separately applied to an electronic component, or may be applied to an electronic component in combination with each other.

In addition, both structures of the groove and the welding wall are marked in FIG. 3 to FIG. 7, however, the groove and the welding wall may be separately applied to different electronic components. This is not limited in this application.

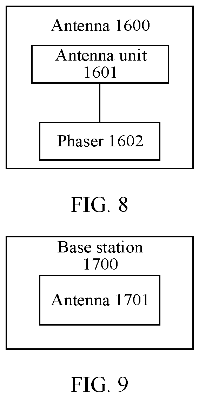

For example, when the electronic component shown in FIG. 3 to FIG. 7 is a phaser, the phaser can be applied to an antenna. An antenna provided by this application is briefly introduced with reference to FIG. 8 at following.

FIG. 8 is a schematic structural diagram of an antenna according to an embodiment of this application. The schematic diagram includes an antenna unit 1601 and any phaser 1602 connected to the antenna unit according to the foregoing embodiment. The antenna unit 1601 is configured to radiate an electromagnetic beam; and the phaser 1602 is configured to adjust an angle of the electromagnetic beam radiated by the antenna unit.

According to the antenna provided in this embodiment of this application, when the phaser 1602 includes the groove 401, the use of an auxiliary plastic component for fixing may be reduced or eliminated, and the fixing of PCB less than 20 mil is implemented. When the phaser 1602 includes the welding wall 404, mechanical processing of a heat-resistance structure can be reduced or eliminated. The use of the two both together or separately can reduce manufacturing costs of the antenna.

FIG. 9 is a schematic structural diagram of abase station according to an embodiment of this application. The base station includes the antenna shown in FIG. 8. The base station 1700 provided in this embodiment of this application includes an antenna 1701. The antenna 1701 includes the phaser described above.

Pay attention, the foregoing description is merely an example in an embodiment of this application. A person skilled in the art can understand that this application is not limited to the specific embodiments described herein. A person skilled in the art can performs various obvious changes, readjustments, mutual combination, and replacements without departing from the protection scope of this application. Therefore, although this application is described in detail by using the foregoing embodiments, this application is not limited to the foregoing embodiments, and may further include more other equivalent embodiments without departing from the concept of this application. The scope of this application is determined by the scope of the appended claims.

## Claims

1. An electronic component, comprising:
a printed circuit board PCB and a cavity, wherein an inner wall of the cavity is provided with at least one groove for fixing the PCB;
a first groove in the at least one groove comprises a first side wall and a second side wall, and the first side wall and the second side wall form an opening of the first groove;
wherein a length of the first side wall in a first direction is greater than that of the second side wall, and the first direction is parallel to a direction of the opening; and
the first side wall is provided with at least one first raised part, the first raised part protrudes from the first side wall to the second side wall along a second direction, and the second direction is perpendicular to the first direction.

2. The electronic component according to claim 1, wherein a vertical distance between a side of the first raised part close to an inner wall of the cavity and the inner wall of the cavity is greater than the length of the second side wall in the first direction.

3. The electronic component according to claim 1 or 2, wherein a distance between an outer end of the first raised part and the second side wall in the second direction is greater than 0.

4. An electronic component, comprising a cavity and at least one welding wall, wherein
the at least one welding wall is disposed on an outer wall of the cavity, at least one end of the welding wall is connected to the outer wall of the cavity, a cavity structure is formed between the welding wall and the outer wall of the cavity, at least one through hole is disposed on the welding wall, and the outer wall of the cavity is provided with an operation hole corresponding to the through hole.

5. The electronic component according to claim 4, wherein the electronic component further comprises: a printed circuit board PCB and a cable, wherein
the PCB is located in the cavity, and
an inner conductor of the cable passes through the through hole and the operation hole and is welded to the PCB, and an outer conductor of the cable is welded to the welding wall.

6. The electronic component according to any one of claims 1 to 5, wherein the electronic component is a phaser.

7. An antenna comprising:
an antenna unit, and
the phaser according to claim 6 and connected to the antenna unit.
